# EUROPEAN PATENT APPLICATION

(11) **EP 4 739 021 A1**
(43) Date of publication of application: **06.05.2026**
(21) Application number: 23943694.2
(22) Date of filing: 30.06.2023
(51) Int. Cl.: H05K 13/04

(54) **SUBSTRATE WORK MACHINE AND METHOD FOR CHANGING ARRANGEMENT OF BACKUP MEMBER**

(71) Applicant: Fuji Corporation, Chiryu-shi, Aichi 472-8686 (JP)
(72) Inventor: NAKAI, Kenji, Chiryu-shi, Aichi 472-8686 (JP)
(74) Representative: Grünecker Patent- und Rechtsanwälte PartG mbB
(86) International application number: PCT/JP2023/024315
(87) International publication number: WO 2025/004303

(57) **Abstract**

A board work machine includes a backup plate having a first placement surface on which a backup member configured to support a board from below is placed, an accommodation section having an opening in the first placement surface, the accommodation section being configured to accommodate the backup member below the first placement surface, and a cover member provided to be openable and closable with respect to the opening of the accommodation section and having a second placement surface on which the backup member is placed in a closed state.

## Description

### Technical Field

The present invention relates to a board work machine and a method for changing an arrangement of a backup member.

### Background Art

A board work machine is used for production of product boards. The board work machine includes a backup device that supports a board from below by a backup member arranged at a predetermined position inside the machine when a predetermined board work is performed. Patent Literature 1 discloses a component mounter that includes a backup device and mounts a component on a board as a board work. The number, type, arrangement position, and the like of a backup member are appropriately set according to a board work scheduled to be performed, the type of board, and a state of a bottom surface (a lower surface of a positioned board) of a board.

### Citation List

### Patent Literature

Patent Literature 1: WO2004/103054A

### Summary of the Invention

### Technical Problem

In a board work machine including a backup device, it is desired to increase the degree of freedom in arrangement of a backup member to more reliably support a board. In addition, in arrangement change processing of the backup member, there is a demand for reducing the time required for the processing.

A first object of the present description is to apply a board work machine capable of increasing the degree of freedom in arrangement of a backup member. In addition, a second object of the present description is to provide a board work machine and a method for changing an arrangement of a backup member, which can improve the efficiency of arrangement change processing of the backup member.

### Solution to Problem

The present description discloses a board work machine including a backup plate having a first placement surface on which a backup member configured to support a board from below is placed, an accommodation section having an opening in the first placement surface, the accommodation section being configured to accommodate the backup member below the first placement surface, and a cover member provided to be openable and closable with respect to the opening of the accommodation section and having a second placement surface on which the backup member is placed in a closed state.

The present description discloses a method for changing an arrangement of a backup member, the method to be applied to a board work machine configured to perform a predetermined board work on a board, the board work machine including a backup plate having a first placement surface on which the backup member configured to support the board from below is placed, an accommodation section having an opening in the first placement surface, the accommodation section being configured to accommodate the backup member below the first placement surface, a cover member provided to be openable and closable with respect to the opening of the accommodation section and having a second placement surface on which the backup member is placed in a closed state, and a control device configured to perform arrangement change processing of moving each of multiple of the backup members from a current position to a target position, the method including: a first step of moving the backup member from the current position to a temporary placement position set on the first installation surface in the arrangement change processing, when an opening/closing operation of the cover member is required; and a second step of moving the backup member from the temporary placement position to the target position after the opening/closing operation of the cover member.

The present description also discloses a technical idea in which "the board work machine according to Claim 2 or 3" in Claim 5 as originally filed is changed to "the board work machine according to any one of Claims 2 to 4", a technical idea in which "the board work machine according to Claim 2 or 3" in Claim 6 as originally filed is changed to "the board work machine according to any one of Claims 2 to 5", and a technical idea in which "the board work machine according to Claim 2 or 3" in Claim 7 as originally filed is changed to "the board work machine according to any one of Claims 2 to 5". In addition, the present description also discloses a technical idea in which "the board work machine according to Claim 2 or 3" in Claim 8 as originally filed is changed to "the board work machine according to any one of Claims 2 to 7", a technical idea in which "the board work machine according to Claim 2 or 3" in Claim 9 as originally filed is changed to "the board work machine according to any one of Claims 2 to 7", and a technical idea in which "the board work machine according to Claim 1 or 2" in Claim 10 as originally filed is changed to "the board work machine according to any one of Claims 1 to 9".

### Advantageous Effects of Invention

According to such a configuration of a board work machine, a backup member can be arranged not only on a first placement surface but also on a second placement surface, and the degree of freedom in arrangement of the backup member in arrangement change processing can be increased. In addition, according to a configuration of a method for changing an arrangement of a backup member, the efficiency of arrangement change processing of the backup member can be improved.

### Brief Description of Drawings

Fig. 1 is a top view schematically illustrating a component mounter as a board work machine according to an embodiment.
Fig. 2 is a side view illustrating a backup device of a board conveyance device.
Fig. 3 is a plan view illustrating the backup device of the board conveyance device.
Fig. 4 is an enlarged side view illustrating a closed state of a cover member of an accommodation device.
Fig. 5 is an enlarged side view illustrating an open state of the cover member of the accommodation device.
Fig. 6 is a flowchart illustrating arrangement change processing of a backup member.
Fig. 7 is a flowchart illustrating processing of setting a temporary placement position and movement.
Fig. 8 is a schematic diagram illustrating a movement path of the backup member that is moved from a current position to a target position via a temporary placement position.

### Description of Embodiments

### 1. Outline of Board Work Machine and Method for Changing Arrangement of Backup Member

A board work machine used for production of product boards includes backup device 50 that supports board 91 from below by backup member 70 arranged at a predetermined position in the machine when performing a predetermined board work. A control device of the board work machine performs arrangement change processing of backup members 70 according to a board work scheduled to be performed. The arrangement change processing of backup member 70 is performed, for example, in a setup work of the board work as necessary. In the present embodiment, component mounter 1 as the board work machine including backup device 50 is illustrated.

### 2. Configuration of Production Line Ln

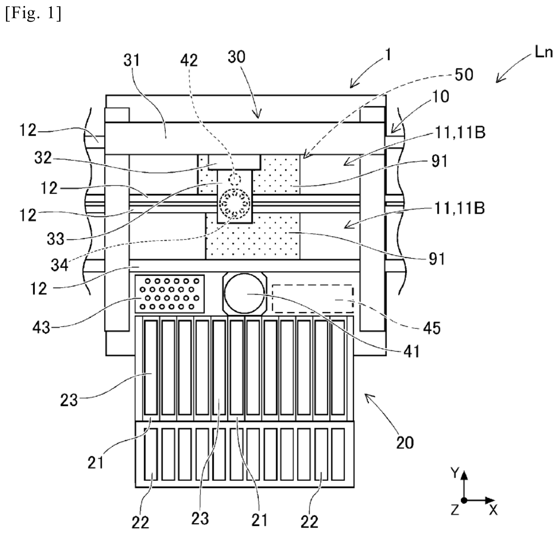

Multiple component mounters 1 are installed side by side together with other board work machines to configure production line Ln. A mounting process of mounting a component on board 91 is performed as a predetermined board work. As illustrated in Fig. 1, production line Ln is configured such that multiple board work machines are installed in a conveyance direction of board 91. Each of the multiple board work machines is communicably connected to a host computer (not illustrated) that collectively controls production line Ln.

The host computer stores arrangement information of backup members 70. The arrangement information indicates arrangement positions of backup members 70 set for a board work corresponding to production of a product board. The arrangement information is downloaded according to a request of a board work machine of each production line Ln and stored in a control device of the board work machine.

Production line Ln is configured with, for example, a printer, a reflow oven, and an inspector as multiple board work machines. The printer prints paste-like solder at a mounting position of a component on loaded board 91. The reflow oven heats board 91 conveyed from an upstream side of production line Ln, melts the solder on board 91, and performs soldering. The inspector inspects whether an appearance or a function of a product board produced by production line Ln is normal.

In the present embodiment, multiple production lines Ln may be configured in a factory of the product board. A configuration of each of multiple production lines Ln can be added or changed appropriately according to, for example, the type of product board to be produced. Specifically, a board work machine, such as a buffer device for temporarily holding board 91 to be conveyed, a board supply device, a board flipping device, various types of inspection devices, a shield mounting device, an adhesive coating device, and an ultraviolet ray irradiation device, can be installed appropriately in multiple production lines Ln.

### 3. Configuration of Component Mounter 1

As illustrated in Fig. 1, component mounter 1 includes board conveyance device 10, component supply device 20, component transfer device 30, part camera 41, board camera 42, nozzle station 43, and control device 45. In the following description, a front-rear direction (up-down direction of Fig. 1) of component mounter 1 which is a horizontal direction is referred to as a Y direction, a left-right direction (left-right direction of Fig. 1) of component mounter 1 which is a horizontal direction intersecting the Y direction is referred to as an X direction, and a vertical direction (front-rear direction of Fig. 1) orthogonal to the X direction and the Y direction is referred to as a Z direction.

### 3-1. Board Conveyance Device 10

Board conveyance device 10 is configured with conveyance mechanisms 11 and the like installed side by side in the Y direction. Each of conveyance mechanisms 11 has pair of guide rails 12 and pair of conveyor belts 13. Pair of guide rails 12 extends in a conveyance direction (X direction) of a board, and supports a peripheral edge of board 91 placed and conveyed on conveyor belt 13. At least one of pair of guide rails 12 is provided on a base stand to be movable in the Y direction.

Board conveyance device 10 subsequently conveys board 91 in the conveyance direction and positions board 91 at a predetermined position in the machine. Board conveyance device 10 has backup device 50 that clamps positioned board 91. Detailed configurations of board conveyance device 10 and backup device 50 will be described below. After performing a mounting process of a component, board conveyance device 10 unloads board 91 to the outside of component mounter 1.

### 3-2. Component Supply Device 20

Component supply device 20 includes multiple slots 21 and multiple reel holding sections 22 arranged side by side in the X direction. Feeder 23 is detachably set in each of multiple slots 21. Feeders 23 feed and move a carrier tape in which multiple components are accommodated to supply the components to be collectable. Reel holding section 22 holds a reel, on which a carrier tape is wound, in an exchangeable manner. In addition, component supply device 20 may supply, for example, relatively large components in a state where components are arranged on a tray placed on a pallet. In the configuration described above, component supply device 20 supplies components by pulling out a predetermined pallet from an accommodation device that accommodates multiple pallets, according to a mounting process.

### 3-3. Component Transfer Device 30

Component transfer device 30 transfers a component supplied by component supply device 20 to a predetermined mounting position on board 91 loaded into the machine by board conveyance device 10. Head drive device 31 of component transfer device 30 moves movement stand 32 in a horizontal direction (the X direction and the Y direction) by a linear motion mechanism. Mounting head 33 is fixed to movement stand 32 in an exchangeable manner by a clamp member (not illustrated). Various tools are detachably attached to mounting head 33.

The tool includes suction nozzle 34 that holds a component. Suction nozzle 34 picks up and holds a component by using supplied negative pressure air. Lifting and lowering positions and angles of suction nozzle 34 with respect to mounting head 33 and a supply state of the negative pressure air are controlled. In addition, a chuck that clamps a component can be attached to mounting head 33 as another tool.

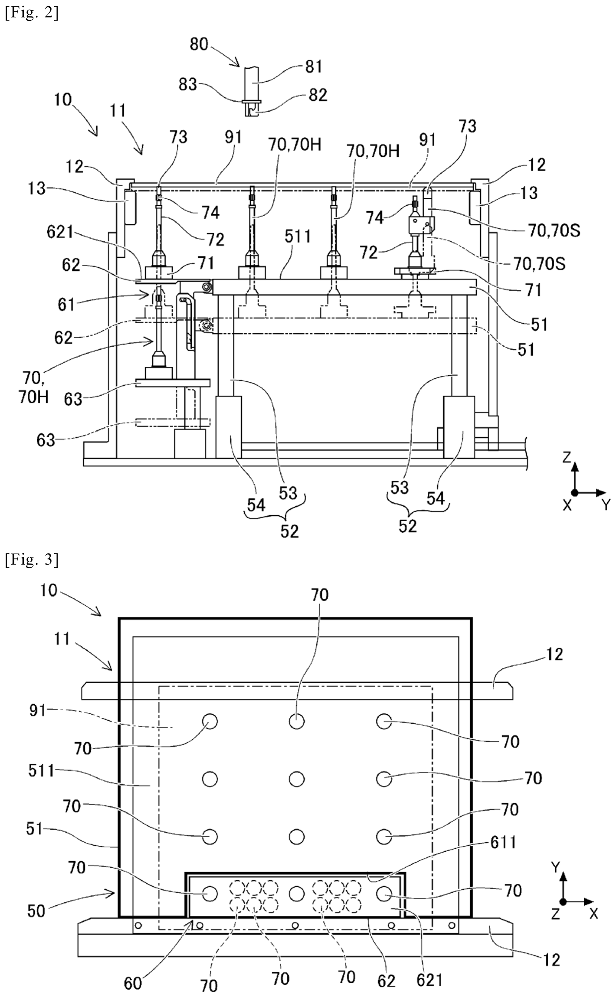

Further, for example, picker 80 (see Fig. 2) that holds backup member 70 by engaging with a predetermined portion of backup member 70 can be detachably attached to mounting head 33 as another tool. As described above, component transfer device 30 is capable of holding backup member 70 in addition to a component, and functions as a movement device that moves backup member 70. Component transfer device 30 is used for arrangement change processing (including increase/decrease and position change) of backup member 70.

### 3-4. Part Camera 41 and Board Camera 42

Part camera 41 and board camera 42 are digital imaging devices each having an imaging element such as CMOS. Part camera 41 and board camera 42 perform imaging based on a control signal and transmit image data acquired through the imaging. Part camera 41 is capable of imaging from below a component held by suction nozzle 34. Board camera 42 is provided on movement stand 32 to be movable in the horizontal directions integrally with mounting head 33. Board camera 42 is capable of imaging board 91 from above.

In addition to having a surface of board 91 as an imaging target, board camera 42 can have various devices or the like as an imaging target as long as the various devices are within a movable range of movement stand 32. For example, board camera 42 can image a reference mark or a barcode attached to nozzle station 43 to be described below and a tool (suction nozzle 34 or picker 80) accommodated in nozzle station 43 within a camera visual field. In this way, board camera 42 can be used to image different imaging targets to acquire image data used for various types of image processing.

### 3-5. Nozzle Station 43

Nozzle station 43 is provided inside component mounter 1. Nozzle station 43 is a tool station that accommodates various tools used for a board work by component mounter 1 as the board work machine. In the present embodiment, nozzle station 43 detachably holds multiple suction nozzles 34 and pickers 80. In an exchange process of suction nozzle 34, nozzle station 43 holds suction nozzle 34 detached from mounting head 33 and also detachably holds another suction nozzle 34. Accordingly, component mounter 1 is configured to automatically exchange suction nozzle 34 according to the type of component of a mounting target, for example, during performance of a mounting process.

Nozzle station 43 is detachably installed on a base stand of component mounter 1. A reference mark and a barcode (not illustrated) are provided on an upper surface of nozzle station 43. The reference mark indicates a reference position on the upper surface of nozzle station 43, and is attached to have a specified positional relationship with respect to an accommodation section that individually accommodates a tool. The barcode indicates identification information of nozzle station 43. In the identification information, identification information and an accommodation position of the tool accommodated in nozzle station 43 are associated with each other. The accommodation position is indicated by, for example, a relative position of the accommodation section with respect to the reference position.

### 3-6. Control Device 45

Control device 45 is mainly configured with CPU, various types of memory, and a control circuit. Control device 45 performs a mounting process of mounting a component on board 91. In the mounting process, control device 45 controls an operation of component transfer device 30 based on information output from various sensors, a result of image processing, a control program stored in advance, or the like. Accordingly, positions and angles of multiple suction nozzles 34 supported by mounting head 33 are controlled. In addition, control device 45 performs arrangement change processing including addition or removal of backup members 70 used for board conveyance device 10 to support board 91 from below in the mounting process, and changing of a position of backup members 70.

Control device 45 stores arrangement information downloaded from a host computer. The "arrangement information" indicates an arrangement position of backup members 70 set for a board work (corresponding to the type of a product board) scheduled to be performed. The arrangement information indicates an arrangement position of backup members 70 and the type (for example, a hard type or a soft type) of backup members 70. In addition to the above description, the arrangement information may include an allowable error of an arrangement of backup members 70 with respect to the arrangement position. The arrangement information is set in advance according to the type (including a size and hardness) of board 91, the type (including a mounting position of a component) of a product board to be produced, a production process, and the like.

### 4. Detailed Configurations of Board Conveyance Device 10 and Backup Device 50

### 4-1. Board Conveyance Device 10

Component mounter 1 of the present embodiment is a double-track conveyor type including multiple conveyance mechanisms 11A and 11B. Pair of guide rails 12 configuring conveyance mechanism 11 is provided on a base stand to be relatively movable in the Y direction. Accordingly, conveyance mechanism 11 adjusts an interval between pair of guide rails 12 according to a dimension of board 91 in the Y direction (see Fig. 3).

### 4-2. Backup Device 50

Backup device 50 supports board 91 conveyed by conveyance mechanism 11 from below, and clamps board 91 between pair of guide rails 12. In the present embodiment, backup device 50 supports board 91 by causing backup member 70 to come into contact with a lower surface of board 91. Accordingly, backup device 50 clamps board 91 between pair of guide rails 12 and maintains a height of a portion being in contact with backup member 70, and thereby, board 91 is prevented from bending.

As illustrated in Fig. 2, backup device 50 includes backup plate 51 and lifting and lowering device 52. Backup plate 51 is arranged to face the lower surface of board 91 positioned by conveyance mechanism 11. Backup plate 51 is provided on a base stand to be liftable and lowerable in the Z direction. In the present embodiment, backup plate 51 is formed to have a rectangular shape as the entire shape. Backup plate 51 has first placement surface 511 on which backup member 70 is detachably placed. First placement surface 511 is an upper surface of backup plate 51.

Lifting and lowering device 52 lifts and lowers backup plate 51 with respect to the base stand. In the present embodiment, lifting and lowering device 52 is configured with multiple air cylinders each having rod 53 and cylinder main body 54. Rods 53 of the multiple air cylinders are detachably fixed to four corners of backup plate 51. Cylinder main body 54 of each air cylinder advances and retracts rod 53 in the Z direction according to air pressure.

Lifting and lowering device 52 of backup device 50 retracts backup member 70 downward from the rear surface of board 91 when board 91 is loaded or unloaded. Accordingly, lifting and lowering device 52 lowers backup plate 51 to a prepared height at which a component (rear surface component) mounted on the rear surface of board 91 does not interfere with backup member 70 (indicated by a two-dot chain line in Fig. 2). In addition, lifting and lowering device 52 lifts backup plate 51 to a backup height (indicated by a solid line of Fig. 2) during performing of a mounting process. Accordingly, backup device 50 pushes up and supports board 91 from below.

### 4-3. Accommodation Device 60

Here, in a predetermined production process (for example, a mounting process by component mounter 1), as set in the arrangement information, the number of backup members 70 (hereinafter, referred to as "required number Nr") required for each production process is arranged at a predetermined position. A surplus of backup members 70 in the machine which is not used for the production process is generally retracted to, for example, a retraction area provided not to interfere with board 91 to be positioned. However, when a size of board 91 that is a target of the production process is great, there is a possibility that a settable retraction area is narrowed.

Therefore, backup device 50 of the present embodiment adopts a configuration having accommodation device 60 that is open on an upper surface of backup plate 51 and can accommodate multiple backup members 70 below backup plate 51. However, when the opening is provided in the upper surface of backup plate 51 as described above, an area of first placement surface 511 is reduced, and the degree of freedom of an arrangement of backup member 70 can be reduced by the reduced area. Therefore, in the present embodiment, backup device 50 adopts a configuration in which backup member 70 can be arranged in the opening portion.

As illustrated in Figs. 2 and 3, accommodation device 60 has accommodation section 61, cover member 62, table 63, guide member 64, bracket 65, and auxiliary lifting and lowering device 66. Accommodation section 61 is a space that opens in first placement surface 511 and can accommodate backup member 70 below first placement surface 511. It is assumed that the "opening" is not only an upper end of a through-hole that penetrates backup plate 51 in an up-down direction but also an upper end of a shape in which a part of an outer edge of backup plate 51 is notched as in the present embodiment. Cover member 62 is provided to be openable and closable with respect to opening 611 of accommodation section 61. As illustrated in Fig. 2, cover member 62 has second placement surface 621 on which backup member 70 is placed in a closed state.

Table 63 is provided below opening 611 to be liftable and lowerable. An upper surface of table 63 is formed in a planar shape in which backup member 70 can be arranged. Guide member 64 is a plate-shaped member in which L-shaped guide groove 641 is formed in the present embodiment. A dimension in an up-down direction from an upper surface (accommodation surface) of table 63 to a lower surface of cover member 62 is set to be slightly greater than a dimension of backup member 70 in an up-down direction.

Guide member 64 is fixed to table 63 and lifts and lowers integrally with table 63. Bracket 65 is fixed to a lower surface of cover member 62. Bracket 65 has guide pin 651 that is movable along guide groove 641. Bracket 65 has support shaft 652 rotatably supported to backup plate 51. Auxiliary lifting and lowering device 66 has the same configuration as lifting and lowering device 52, and lifts and lowers table 63 independently of backup plate 51.

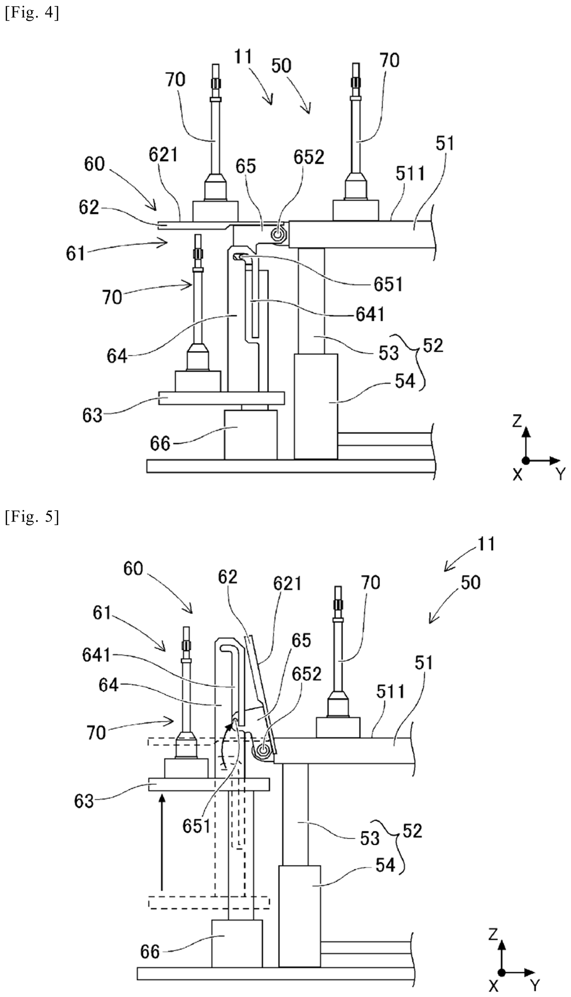

In accommodation device 60 configured as described above, as illustrated in Fig. 4, lifting and lowering device 52 and auxiliary lifting and lowering device 66 operate in synchronization with each other, and accordingly, table 63 and cover member 62 can be integrally lifted and lowered with respect to backup plate 51. In addition, accommodation device 60 can relatively lift table 63 with respect to backup plate 51, thereby shifting cover member 62 from a closed state to an open state as illustrated in Fig. 5.

In detail, when table 63 relatively lifts with respect to backup plate 51, guide pin 651 moves toward an end portion of a short side of guide groove 641 while approaching support shaft 652 at the same height. Accordingly, cover member 62 and bracket 65 rotate about support shaft 652. When table 63 is further lifted, guide pin 651 moves toward a corner of guide groove 641. Accordingly, cover member 62 and bracket 65 are rotated to the greatest angle about support shaft 652. That is, cover member 62 is shifted from a closed state to an open state.

Thereafter, when table 63 is lifted, guide pin 651 moves along a long side of guide groove 641. Accordingly, table 63 and guide member 64 are lifted while an angle of the open state of cover member 62 is maintained. When the lifting of table 63 has been completed, as illustrated in Fig. 5, cover member 62 is in an open state, and backup member 70 accommodated in accommodation section 61 is moved to a height at which backup member 70 can be collected by picker 80. In this way, auxiliary lifting and lowering device 66 of accommodation device 60 configures a drive mechanism that lifts and lowers arranged backup member 70, and configures an opening/closing mechanism that opens and closes cover member 62.

As described above, cover member 62 is opened, and backup member 70 can be taken out from a predetermined accommodation position of accommodation section 61 through opening 611 or backup member 70 can be accommodated. In addition, in accommodation device 60, by relatively lowering table 63 with respect to backup plate 51, guide pin 651 moves along guide groove 641 in a reverse order of the above description, and cover member 62 is shifted from an open state to a closed state. In the closed state of cover member 62, second placement surface 621 that is an upper surface of cover member 62 configures the same plane as first placement surface 511, and becomes a surface on which backup member 70 can be placed in the same manner as first placement surface 511.

According to the configuration described above, spare backup member 70 can be accommodated without providing a retraction area for retracting spare backup member 70 not used for supporting board 91 on first placement surface 511. In addition, by causing cover member 62 to be in a closed state to close opening 611 of accommodation section 61, backup member 70 can be arranged on second placement surface 621 that is an upper surface of cover member 62. Accordingly, backup member 70 can also be arranged on second placement surface 621 in addition to first placement surface 511, and the degree of freedom in arranging backup member 70 in arrangement change processing can be increased.

### 4-4. Backup Member 70

Here, backup member 70 is detachably arranged on first placement surface 511 or second placement surface 621. In the present embodiment, backup member 70 includes hard pin 70H having support section 53 configured with a relatively hard member (for example, a metal member) at a front end, and soft pin 70S having support section 73 configured with a relatively soft member (for example, a rubber member). In backup member 70, support section 73 is connected to base section 71 through body section 72. A magnet is buried in base section 71 located at a lower end, and backup member 70 is fixed to backup plate 51 or cover member 62 by magnetic force. In addition, in backup member 70, engagement section 74 having the same shape is formed above base section 71. Engagement section 74 engages with picker 80 attached to mounting head 33.

### 4-5. Picker 80

Picker 80 has main body section 81 and collection section 82. Main body section 81 is formed in a cylindrical shape as the entire shape. Main body section 81 is formed to be attachable to mounting head 33 in the same manner as suction nozzle 34. Collection section 82 is provided at a lower end of main body section 81. Collection section 82 is engaged with engagement section 74 of hard pin 70H and engagement section 74 of soft pin 70S. In order to maintain a state of holding hard pin 70H or soft pin 70S, picker 80 presses a front end of engagement section 74 by an elastic force of an elastic member provided inside main body section 81, and biases a lower end portion of engagement section 74 toward collection section 82.

### 5. Arrangement Change Processing of Backup Member 70

### 5-1. Outline of Arrangement Change Processing

For example, before performing a mounting process (next board work) corresponding to a predetermined product board, control device 45 of component mounter 1 performs arrangement change processing of backup member 70 based on arrangement information by using component transfer device 30 that functions as a movement device of backup member 70. The purpose of performing the arrangement change processing is to handle, for example, the type of backup member 70 and a position where backup member 70 is to be arranged, which may change depending on a dimension of board 91 and the number and positions of components to be mounted.

When the type of product board to be produced changes, component mounter 1 performs arrangement change processing of backup members 70 as one of setup works as necessary. The arrangement change processing includes not only fixing backup member 70 to backup plate 51 located below board 91 and accommodating backup member 70 in accommodation device 60. The accommodation of backup member 70 is a process of moving spare backup member 70 that is not used to support board 91 to a predetermined accommodation position in accommodation section 61.

When performing the arrangement change processing of backup members 70, control device 45 attaches picker 80 capable of holding backup member 70 to mounting head 33. Picker 80 is accommodated in nozzle station 43 and exchanged with suction nozzle 34 attached to mounting head 33. Control device 45 drives component transfer device 30 to appropriately move backup member 70 of a target to a position indicated by arrangement information.

Here, component mounter 1 configured as described above can automatically perform all the arrangement change processing of backup members 70 in a setup work. Specifically, in the setup work of the next mounting process, control device 45 individually moves backup member 70 by using picker 80 based on arrangement information described above, position information indicating a current position of each backup member 70 used in the current mounting process, and spare information indicating a current position of spare backup member 70 placed in accommodation section 61.

Then, after an arrangement of all backup members 70 is completed, control device 45 causes a nozzle station to accommodate picker 80 and ends the arrangement change processing. In addition, control device 45 updates and stores spare information and position information indicating a target region in which backup member 70 is placed inside component mounter 1 and a current position (accommodation position) of backup member 70 arranged in accommodation section 61. Accordingly, control device 45 can perform the arrangement change processing of backup members 70 without movement by a worker.

Here, as in the present embodiment, in a configuration in which backup member 70 can be accommodated in accommodation section 61 provided below first placement surface 511 and backup member 70 can be placed on second placement surface 621 which is an upper surface of cover member 62 closing opening 611 of accommodation section 61, it is necessary to set a state in which backup member 70 is not placed on second placement surface 621 when cover member 62 is opened and closed. In addition, in addition to performance timing of an opening/closing operation of cover member 62, the efficiency of arrangement change processing of backup members 70 can be suitably improved. Therefore, in the present embodiment, the following method is adopted for arrangement change processing of backup members 70 to improve efficiency of the processing.

### 5-2. Details of Arrangement Change Processing

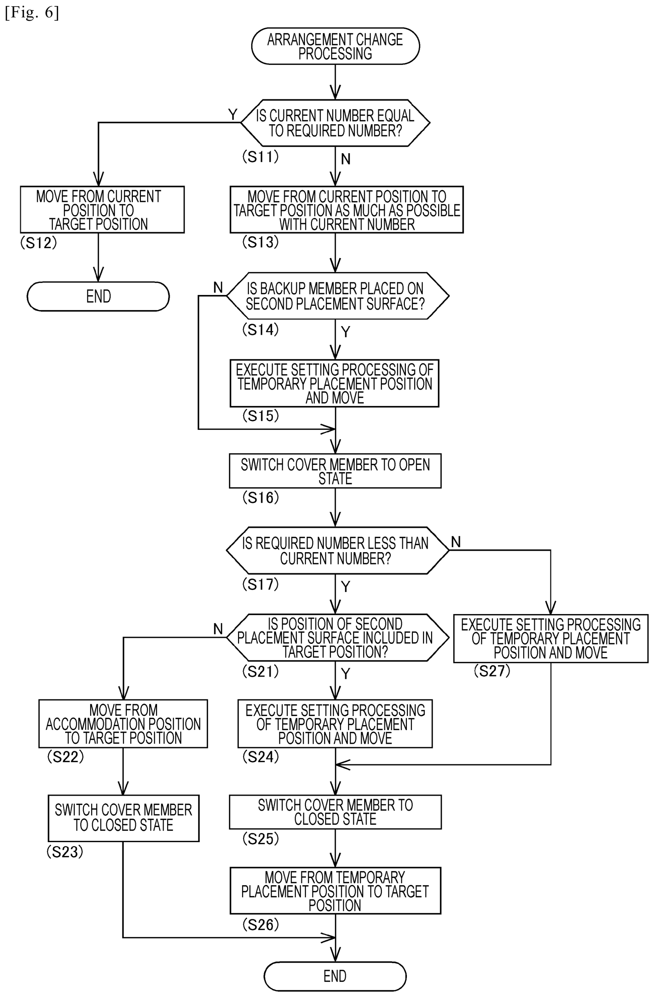

For example, in a setup work, control device 45 performs arrangement change processing as illustrated in Fig. 6. First, control device 45 determines whether current number Nc of unprocessed backup members 70 arranged on first placement surface 511 and second placement surface 621 is equal to required number Nr of processed backup members 70 (S11). When current number Nc is equal to required number Nr (S11: Yes), control device 45 determines that there is no excess or deficiency of backup members 70 and backup member 70 is not required to be taken in or out of accommodation section 61, and moves backup member 70 from current position Pc to target position Pt (S12).

To the contrary, when current number Nc is not equal to required number Nr (S11: No), control device 45 moves backup members 70 from current position Pc to target position Pt as much as possible with current number Nc (S13). That is, when current number Nc is less than required number Nr, control device 45 performs an arrangement change by current number Nc (S13) and takes out the shortage from accommodation section 61. In addition, when current number Nc is greater than required number Nr, control device 45 performs an arrangement change by required number Nr (S13) and accommodates the surplus in accommodation section 61. In the arrangement change described above, control device 45 skips the movement when target position Pt is on second placement surface 621.

Next, control device 45 determines whether backup member 70 is placed on second placement surface 621 which is an upper surface of cover member 62 (S14). When backup member 70 is placed on second placement surface 621 (S14: Yes), control device 45 performs setting processing of temporary placement position Pr (S15). Temporary placement position Pr is set on first placement surface 511 and corresponds to a via position when moving from current position Pc to target position Pt. Details of the setting processing of temporary placement position Pr will be described below.

When backup member 70 is not placed on second placement surface 621 (S14: No), or after backup member 70 placed on second placement surface 621 is moved to temporary placement position Pr (S15), control device 45 switches cover member 62 from a closed state to an open state (S16). In detail, control device 45 causes an operation of auxiliary lifting and lowering device 66 to relatively lift table 63 to backup plate 51. Thereafter, control device 45 adjusts heights of backup plate 51 and table 63 such that picker 80 attached to mounting head 33 can collect backup member 70 (see Fig. 5).

Subsequently, control device 45 determines whether required number Nr is less than current number Nc used for the determination of S11 (S17). When current number Nc is less than required number Nr (S17: Yes), control device 45 determines that the number of backup members 70 taken out from accommodation section 61 is insufficient, and performs processing of taking out backup member 70 as follows. When a position of second placement surface 621 is not included in target position Pt of backup member 70 taken out from accommodation section 61 (S21: No), control device 45 moves taken-out backup member 70 from the accommodation position to target position Pt (S22).

In these cases (S21: No and S22), target position Pt is not present on second placement surface 621, and accordingly, an arrangement of all backup members 70 is completed by newly taking out backup member 70 from accommodation section 61. Therefore, control device 45 switches cover member 62 from an open state to a closed state (S23), and ends the arrangement change processing of backup members 70. In the shifting to the closed state, control device 45 causes an operation of auxiliary lifting and lowering device 66 to relatively lower table 63 with respect to backup plate 51. Accordingly, cover member 62 is closed.

In addition, when a position of second placement surface 621 is included in target position Pt of backup member 70 taken out from accommodation section 61 (S21: Yes), setting processing of temporary placement position Pr and movement is performed (S24). The processing of setting temporary placement position Pr and movement is the same as S15, and will be described in detail below. Regarding backup member 70 of which target position Pt is set on first placement surface 511 among multiple backup members 70 taken out from accommodation section 61, control device 45 directly moves backup member 70 from an accommodation position thereof to target position Pt as in S22.

As described above, after backup member 70 taken out from accommodation section 61 is moved to temporary placement position Pr or target position Pt, control device 45 switches cover member 62 from an open state to a closed state (S25). Thereafter, control device 45 moves backup member 70 arranged in temporary placement position Pr to target position Pt (S26), and ends the arrangement change processing of backup member 70.

In addition, when required number Nr is greater than current number Nc used for the determination of S11 (S17: No), control device 45 determines that there is an excess in the number of backup members 70 taken out from accommodation section 61, and performs accommodation processing of backup members 70 as follows. Control device 45 moves backup member 70 placed on first placement surface 511 or backup member 70 moved to temporary placement position Pr in S15 to a predetermined accommodation position of accommodation section 61 (S27).

As described above, after moving surplus backup member 70 to accommodation section 61, control device 45 switches cover member 62 from an open state to a closed state (S25). Thereafter, when there is backup member 70 arranged in temporary placement position Pr, control device 45 moves backup member 70 to target position Pt (S26). In these cases (S17: No and S27), a position of second placement surface 621 is not included in target position Pt, and in this case, a movement (S26) from temporary placement position Pr to target position Pt is omitted.

### 5-3. Setting Processing of Temporary Placement Position Pr

Details of setting processing (S15 and S24) of temporary placement position Pr in the arrangement change processing of backup member 70 will be described. In the arrangement change processing, when current number Nc of backup members 70 taken out from accommodation section 61 is not equal to required number Nr (S11: No), control device 45 determines that an opening/closing operation of cover member 62 is required to accommodate or take out backup members 70.

Then, when the opening/closing operation of cover member 62 is required, control device 45 temporarily moves backup member 70 to temporary placement position Pr as necessary to set a state in which backup member 70 is not arranged on second placement surface 621 during the opening/closing operation of cover member 62. Even when cover member 62 is in the opening/closing operation, backup member 70 is not arranged on second placement surface 621 before the opening/closing operation, and when target position Pt of backup member 70 newly taken out from accommodation section 61 is a position of first placement surface 511, a temporary movement to temporary placement position Pr is omitted.

When the opening/closing operation (S16, S23, and S25) of cover member 62 is required, control device 45 performs first steps (S15 and S24) of moving backup member 70 from current position Pc to temporary placement position Pr set on first placement surface 511, and second steps (S26 and S27) of moving backup member 70 from temporary placement position Pr to target position Pt after the opening/closing operation (S16 and S25) of cover member 62.

Here, control device 45 may set one candidate in which backup member 70 is not present, among candidates of temporary placement position Pr set in advance on first placement surface 511, as temporary placement position Pr. In this aspect, on first placement surface 511, for example, multiple candidate positions where backup member 70 can be temporarily placed are set in a predetermined area of first placement surface 511 corresponding to a retraction area where spare backup member 70 is retracted. Then, when it is required to move to temporary placement position Pr, control device 45 selects a candidate position that has a predetermined priority (for example, priority is given to a candidate position having a smaller identification number) and is an empty position where backup member 70 is not arranged from among the multiple candidate positions, and sets the selected candidate position as temporary placement position Pr.

According to the configuration described above, temporary placement position Pr is set from a candidate set in advance, and accordingly, a processing load can be reduced. However, depending on set temporary placement position Pr, a movement distance may be redundant when considering a positional relationship between current position Pc and target position Pt. Therefore, control device 45 may dynamically set temporary placement position Pr based on current position Pc and target position Pt of backup member 70 that is a movement target and a position of another backup member 70.

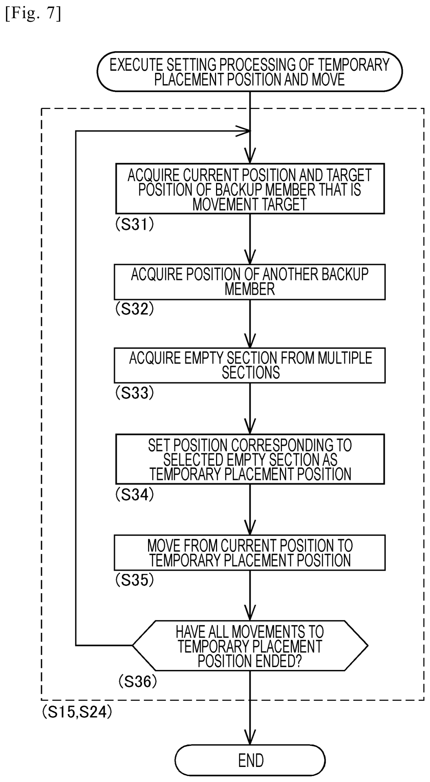

For example, control device 45 may set, as temporary placement position Pr, a position that avoids interference with another backup member 70 from a position on first placement surface 511 of the shortest path connecting current position Pc of backup member 70 that is a movement target to target position Pt. In addition, control device 45 may adopt the following method as a configuration for setting suitable temporary placement position Pr while reducing a processing load. As illustrated in Fig. 7, control device 45 first acquires current position Pc and target position Pt of backup member 70 that is a movement target from position information and arrangement information (S31).

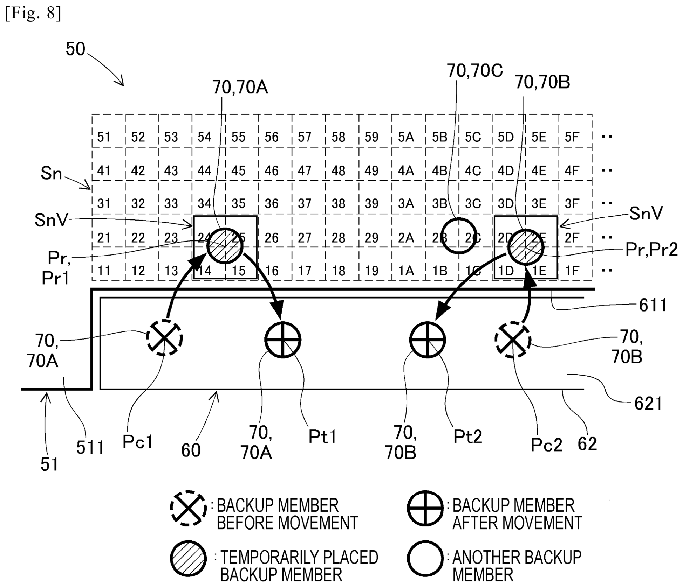

Next, control device 45 acquires a position of another backup member 70 (S32). This position corresponds to target position Pt of backup member 70 when movement of another backup member 70 is completed. Control device 45 acquires empty section SnV in which backup member 70 is not present among multiple sections Sn formed by dividing first placement surface 511 (S33). As illustrated in Fig. 8, "multiple sections Sn" are obtained by dividing, for example, first placement surface 511 at predetermined intervals, and an identification number is assigned to each section Sn.

Control device 45 recognizes one to four sections Sn occupied by backup member 70 based on a position of another backup member 70. Control device 45 determines that section Sn including a part of another backup member 70 is occupied by another backup member 70, and restricts backup member 70 that is a movement target from being arranged in section Sn to avoid interference. Control device 45 recognizes multiple empty sections SnV that are sections Sn not occupied by another backup member 70.

Based on current position Pc and target position Pt of backup member 70 that is a movement target, control device 45 selects empty section SnV such that a movement path via empty section SnV is shortened. Then, control device 45 sets a position corresponding to selected empty section SnV as temporary placement position Pr (S34). Here, control device 45 sets a center position of four empty sections SnV as temporary placement position Pr to avoid interference with another backup member 70.

Control device 45 moves backup member 70 that is a movement target from current position Pc to temporary placement position Pr (S35). When the movement to temporary placement position Pr has not completed for all backup members 70 that are a movement target (S36: No), control device 45 repeatedly performs the above-described processing (S31 to S35).

Accordingly, for example, as illustrated in Fig. 8, backup member 70A arranged on second placement surface 621 is moved to temporary placement position Pr1 corresponding to empty sections Sn (14, 15, 24, and 25) in which a distance from a straight line passing through current position Pc1 and target position Pt is shortened (S15 and S35). After cover member 62 is opened (S16), backup member 70A is moved to a predetermined accommodation position that is target position Pt1 set inside accommodation section 61 (S27).

In addition, for example, as illustrated in Fig. 8, after cover member 62 is opened (S16), backup member 70B accommodated in a predetermined accommodation position inside accommodation section 61 as current position Pc2 is moved to temporary placement position Pr2 corresponding to empty sections Sn (1D, 1E, 2D, and 2E) in which the interference with another backup member 70C already arranged is avoided and a temporarily placed path is the shortest (S24 and S35). After cover member 62 is closed (S25), backup member 70B is moved to target position Pt2 on second placement surface 621 (S26).

According to the above-described configuration, backup member 70 can be arranged on second placement surface 621 in addition to first placement surface 511, and the degree of freedom in arranging backup member 70 in the arrangement change processing can be increased. In addition, with the configuration of the method for changing an arrangement (Figs. 7 and 8) of backup member 70, suitable temporary placement position Pr can be set as necessary, and accordingly, the efficiency of arrangement change processing of backup member 70 can be improved.

### 6. Modification Aspect of Embodiment

In the embodiment, a board work machine is assumed to be component mounter 1 that mounts components on board 91. In contrast to this, the present invention can be applied to other board work machines as long as board 91 is supported by backup member 70 and the arrangement of backup member 70 can be automatically changed by using a work head. For example, the board work machine may perform solder printing as a board work, and coat board 91 with a bonding member by using a work head, or inspect an appearance and a function of board 91.

The embodiment adopts a configuration in which an opening/closing mechanism of cover member 62 is driven by relatively lifting and lowering table 63 with respect to backup plate 51. In contrast to this, the opening/closing mechanism of cover member 62 may include, for example, a drive motor that rotates cover member 62 around support shaft 652, and may be configured to be able to open and close cover member 62 regardless of relative lifting and lowering of table 63. In this configuration as well, the same effects as in the embodiment are obtained.

### Reference Signs List

1: Component mounter (board work machine), 10: board conveyance device, 20: component supply device, 30: component transfer device, 31: head drive device, 32: movement stand, 33: mounting head (work head), 34: suction nozzle, 45: control device, 50: backup device, 51: backup plate, 511: first placement surface, 60: accommodation device, 61: accommodation section, 611: opening, 62: cover member, 621: second placement surface, 63: table, 64: guide member, 641: guide groove, 65: bracket, 651: guide pin, 652: support shaft, 66: auxiliary lifting and lowering device, 70: backup member, 80: picker, 91: board, Pc: current position, Pt: target position, Pr: temporary placement position, Nc: current number, Nr: required number, Sn: section, SnV: empty section

## Claims

1. A board work machine comprising:
a backup plate having a first placement surface on which a backup member configured to support a board from below is placed;
an accommodation section having an opening in the first placement surface, the accommodation section being configured to accommodate the backup member below the first placement surface; and
a cover member provided to be openable and closable with respect to the opening of the accommodation section and having a second placement surface on which the backup member is placed in a closed state.

2. The board work machine according to Claim 1, further comprising:
a control device configured to perform arrangement change processing of moving each of multiple of the backup members from a current position to a target position, wherein,
in the arrangement change processing, when an opening/closing operation of the cover member is required, the control device moves the backup member from the current position to a temporary placement position set on the first placement surface, and moves the backup member from the temporary placement position to the target position after the opening/closing operation of the cover member.

3. The board work machine according to Claim 2, wherein when a current number of the backup members before processing is different from a required number of the backup members after processing, the control device determines that the opening/closing operation of the cover member is required to accommodate or take out the backup member.

4. The board work machine according to Claim 2 or 3, wherein the control device sets the temporary placement position based on the current position and the target position of the backup member that is a movement target.

5. The board work machine according to Claim 2 or 3, wherein the control device sets the temporary placement position based on a position of another backup member different from the backup member that is a movement target.

6. The board work machine according to Claim 2 or 3, wherein the control device selects an empty section in which the backup member is not present among multiple sections formed by dividing the first placement surface, and sets a position corresponding to the empty section as the temporary placement position.

7. The board work machine according to Claim 2 or 3, wherein the control device sets, as the temporary placement position, one candidate in which the backup member is not present among candidates of the temporary placement position set in advance on the first placement surface.

8. The board work machine according to Claim 2 or 3, wherein in the arrangement change processing, when the opening/closing operation of the cover member is required, and when the current position of the backup member that is a movement target is on the second placement surface, and the target position is inside the accommodation section, the control device moves the backup member to the temporary placement position, sets the cover member to an open state, and then accommodates the backup member in the accommodation section.

9. The board work machine according to Claim 2 or 3, wherein in the arrangement change processing, when the opening/closing operation of the cover member is required, and when the current position of the backup member that is a movement target is inside the accommodation section and the target position is on the second placement surface, the control device sets the cover member to an open state, moves the backup member to the temporary placement position, sets the cover member to a closed state, and then moves the backup member to the target position.

10. The board work machine according to Claim 1 or 2, wherein
the board work machine is a component mounter including
a board conveyance device configured to convey the board to a predetermined position in the component mounter and to position the board by using the backup member, and
a mounting head configured to mount a component on the positioned board.

11. The board work machine according to Claim 10, wherein the mounting head is provided with a picker capable of holding the backup member, and moves the backup member by using the picker.

12. A method for changing an arrangement of a backup member, the method to be applied to a board work machine configured to perform a predetermined board work on a board, the board work machine including a backup plate having a first placement surface on which the backup member configured to support the board from below is placed, an accommodation section having an opening in the first placement surface, the accommodation section being configured to accommodate the backup member below the first placement surface, a cover member provided to be openable and closable with respect to the opening of the accommodation section and having a second placement surface on which the backup member is placed in a closed state, and a control device configured to perform arrangement change processing of moving each of multiple of the backup members from a current position to a target position, the method comprising:
a first step of moving the backup member from the current position to a temporary placement position set on the first placement surface in the arrangement change processing, when an opening/closing operation of the cover member is required; and
a second step of moving the backup member from the temporary placement position to the target position after the opening/closing operation of the cover member.
